# EUROPEAN PATENT APPLICATION

(11) **EP 4 738 362 A1**
(43) Date of publication of application: **06.05.2026**
(21) Application number: 25211959.9
(22) Date of filing: 29.10.2025
(51) Int. Cl.: G11C 11/401

(54) **CAPACITOR-LESS MEMORY DEVICE**

(30) Priority: 01.11.2024 KR 20240153634; 02.07.2025 KR 20250088693
(71) Applicant: POSTECH Research and Business Development Foundation, Pohang-si, Gyeongsangbuk-do 37673 (KR)
(72) Inventor: KANG, Dae Hwan, Pohang-si, Gyeongsangbuk-do 37673 (KR); RYU, Yong Woo, Pohang-si, Gyeongsangbuk-do 37673 (KR)
(74) Representative: Jung, Minkyu

(57) **Abstract**

A capacitor-less memory device according to an aspect of the present invention may include a memory cell comprising a write transistor including a first gate, a first drain, and a first source, and a read transistor including a second gate, a second drain, a second source, and a back gate, wherein the second drain is connected to the first drain and the second gate is connected to the first source to operate as a storage node. A bit line may be commonly connected to the first drain and the second drain, a word line may be connected to the first gate, and a control line may be connected to the back gate. The read transistor may be turned on or turned off depending on a data state of the storage node or a control voltage applied to the control line.

## Description

### CROSS-REFERENCE TO RELATED PATENT APPLICATION

This application claims the benefit under 35 U.S.C. § 119 of Korean Patent Application Nos. 10-2024-0153634, filed on November 1, 2024, and 10-2025-0088693, filed on July 2, 2025, the disclosure of which is hereby incorporated by reference in its entirety.

This invention was supported by the research project funded by the Ministry of Trade, Industry and Energy and the Korea Planning & Evaluation Institute of Industrial Technology, under Project Unique Number 2410000277 and Project Number 00235402.

### BACKGROUND

### 1. Field of the Invention

The present invention relates to a semiconductor device, and more particularly, to a memory device capable of storing data without a capacitor.

### 2. Description of the Related Art

In general, memory devices can be classified into volatile devices, in which data disappears when power is turned off, and non-volatile devices, in which data is retained even when power is turned off. Among volatile devices, a dynamic random access memory (DRAM) device typically stores data by using a capacitor, and research has been conducted to increase data capacity by increasing the capacitance of the capacitor.

A typical DRAM device forms a memory cell with one transistor and one capacitor (1T-1C). However, in the DRAM device, as the volume of the capacitor increases, there is a limitation in improving integration density, and the difficulty of manufacturing also significantly increases. Accordingly, research has been conducted on a capacitor-less DRAM capable of operating in the same manner as a conventional DRAM device without a capacitor.

Conventionally, a capacitor-less DRAM device implements a memory operation with two transistors (2T-0C) without a capacitor. However, when the device is implemented in a planar type, a relatively large cell area is still required, and a process of three-dimensionally stacking the device to improve integration density is difficult to achieve. In addition, when the device is implemented in a vertical type, although there is an advantage in that the area can be reduced, it is still difficult to perform a three-dimensional stacking process to further improve integration density.

### SUMMARY OF THE INVENTION

The present invention has been made to address the above-described and other problems, and it is an object of the present invention to provide a capacitor-less memory device capable of achieving high integration and facilitating a stacking process. However, such an object is merely exemplary, and the scope of the present invention should not be limited thereby.

According to an aspect of the present invention, a capacitor-less memory device may include a memory cell comprising a write transistor including a first gate, a first drain, and a first source, and a read transistor including a second gate, a second drain, a second source, and a back gate, wherein the second drain is connected to the first drain and the second gate is connected to the first source to operate as a storage node. A bit line may be commonly connected to the first drain and the second drain, a word line may be connected to the first gate, and a control line may be connected to the back gate. The read transistor may be turned on or turned off depending on a data state of the storage node or a control voltage applied to the control line.

In the capacitor-less memory device, to store a first data state in the storage node of the memory cell, a write operation voltage may be applied to the bit line and the word line, and a precharge voltage or an off voltage may be applied to the control line.

In the capacitor-less memory device, to store a second data state in the storage node of the memory cell, a write operation voltage may be applied to the word line, an off voltage may be applied to the bit line, and a precharge voltage or an off voltage may be applied to the control line.

In the capacitor-less memory device, to read a data state of the memory cell, an off voltage may be applied to the word line and the control line, and a degree of voltage drop may be sensed at the bit line.

The capacitor-less memory device may further include a select line connected to the second source.

In the capacitor-less memory device, to store a first data state in the storage node of the memory cell, a write operation voltage may be applied to the bit line and the word line, an off voltage or a precharge voltage may be applied to the control line, and a precharge voltage or a write operation voltage may be applied to the select line.

In the capacitor-less memory device, to store a second data state in the storage node of the memory cell, a write operation voltage may be applied to the word line, an off voltage may be applied to the bit line, an off voltage or a precharge voltage may be applied to the control line, and a precharge voltage or an off voltage may be applied to the select line.

In the capacitor-less memory device, to read a data state of the memory cell, an off voltage may be applied to the word line and the control line, an off voltage may be applied to the select line, and a degree of voltage drop may be sensed at the bit line.

According to another aspect of the present invention, a capacitor-less memory device may include a plurality of vertically stacked memory cells, the plurality of memory cells including a plurality of write transistors each having a first gate, a first drain, and a first source, and a plurality of read transistors each having a second gate, a second drain, a second source, and a back gate, wherein the second gate is connected to the first source to operate as a storage node, the plurality of read transistors being vertically connected to one another, a bit line connected to the first drains of the plurality of memory cells and to the second drain of an uppermost one of the plurality of read transistors, a plurality of word lines respectively connected to the first gates of the plurality of memory cells, a plurality of control lines respectively connected to the back gates of the plurality of memory cells, and a select line connected to the second source of a lowermost one of the plurality of read transistors, wherein each read transistor may be turned on or turned off depending on a data state of the storage node or a control voltage applied to the back gate.

In the capacitor-less memory device, to store a first data state in the storage node of a selected one of the plurality of memory cells, a write operation voltage may be applied to the bit line, a write operation voltage may be applied to the word line connected to the selected memory cell among the plurality of word lines, an off voltage may be applied to the remaining word lines, an off voltage or a precharge voltage may be applied to the control line, and a precharge voltage or a write operation voltage may be applied to the select line.

In the capacitor-less memory device, to store a second data state in the storage node of a selected one of the plurality of memory cells, an off voltage may be applied to the bit line, a write operation voltage may be applied to the word line connected to the selected memory cell among the plurality of word lines, an off voltage may be applied to the remaining word lines, an off voltage or a precharge voltage may be applied to the control line, and a precharge voltage or an off voltage may be applied to the select line.

In the capacitor-less memory device, to read a data state of a selected one of the plurality of memory cells, an off voltage may be applied to the plurality of word lines, an off voltage may be applied to the control line connected to the back gate of the selected memory cell among the plurality of control lines, a precharge voltage may be applied to the remaining control lines, an off voltage may be applied to the select line, and a degree of voltage drop may be sensed at the bit line.

According to still another aspect of the present invention, a capacitor-less memory device may include a plurality of first semiconductor layers stacked on a substrate and spaced apart from each other, a plurality of first gate electrode layers disposed between the plurality of first semiconductor layers, a first gate insulating layer interposed between the plurality of first semiconductor layers and the plurality of first gate electrode layers, a plurality of first drain electrode layers respectively connected to sides of the plurality of first semiconductor layers, a plurality of first source electrode layers respectively connected to opposite sides of the plurality of first semiconductor layers, a plurality of second gate electrode layers respectively connected to the plurality of first source electrode layers, a second semiconductor layer extending vertically across the plurality of second gate electrode layers; a plurality of back gate electrode layers respectively disposed on opposite sides of the second semiconductor layer from the plurality of second gate electrode layers, a second gate insulating layer interposed between the plurality of second gate electrode layers and the second semiconductor layer and between the plurality of back gate electrode layers and the second semiconductor layer, a plurality of word lines respectively connected to the plurality of first gate electrode layers, and a bit line connected to the plurality of first drain electrode layers and connected to an upper end of the second semiconductor layer, wherein the plurality of second gate electrode layers are respectively used as a plurality of storage nodes.

In the capacitor-less memory device, the bit line may include a vertical electrode that extends vertically to be connected to the plurality of first drain electrode layers, and a horizontal electrode that extends horizontally to be connected to an upper end of the second semiconductor layer and connected to the vertical electrode.

In the capacitor-less memory device, the first source electrode layer and the second gate electrode layer, which are disposed in the same layer among the plurality of first source electrode layers and the plurality of second gate electrode layers, may be integrally formed with each other.

In the capacitor-less memory device, portions of the second semiconductor layer facing the plurality of second gate electrode layers may function as channel layers, and portions of the second semiconductor layer located between the channel layers may function as second drain electrode layers or second source electrode layers.

In the capacitor-less memory device, the plurality of first semiconductor layers may have a planar shape, and the second semiconductor layer may have a pillar shape.

In the capacitor-less memory device, the plurality of first semiconductor layers and the second semiconductor layer may include an oxide semiconductor material.

In the capacitor-less memory device, the device may further include an interlayer insulating layer on the substrate, and via electrodes formed in the interlayer insulating layer to connect the substrate and a lower end of the second semiconductor layer, or to connect the substrate and the bit line.

As described above, according to some embodiments of the capacitor-less memory device of the present invention, it is possible to increase the integration density by using a memory cell that includes two transistors, namely, a write transistor and a read transistor, without a capacitor, while connecting a bit line commonly to both drains and employing a back-gate structure to reduce the cell area. Furthermore, the integration density can be further increased through three-dimensional stacking. Of course, the scope of the present invention is not limited by these effects.

### BRIEF DESCRIPTION OF THE DRAWINGS

FIG. 1 is a schematic circuit diagram illustrating a capacitor-less memory device according to an embodiment of the present invention.
FIG. 2 is a timing chart exemplarily illustrating an operation of the capacitor-less memory device of FIG. 1.
FIG. 3 is a graph showing a voltage change of a bit line during a read operation of the capacitor-less memory device of FIG. 1.
FIG. 4 is a schematic circuit diagram illustrating a capacitor-less memory device according to another embodiment of the present invention.
FIGS. 5 through 10 are schematic circuit diagrams illustrating methods of operating the capacitor-less memory device of FIG. 4.
FIGS. 11A and 11B are schematic perspective views showing a capacitor-less memory device according to still another embodiment of the present invention, as viewed from the front and the back
FIG. 12 is a schematic cross-sectional view of the capacitor-less memory device of FIGS. 11A and 11B.

### DETAILED DESCRIPTION OF THE INVENTION

Hereinafter, preferred embodiments of the present invention will be described in detail with reference to the accompanying drawings.

The embodiments of the present invention are provided to more fully describe the invention to those skilled in the art, and various modifications can be made in many different forms. Therefore, the scope of the present invention is not limited to the embodiments described below. Rather, these embodiments are provided to make this disclosure thorough and complete and to fully convey the scope of the invention to those skilled in the art. In addition, the thicknesses or sizes of the respective layers shown in the drawings may be exaggerated for the sake of clarity and convenience of explanation.

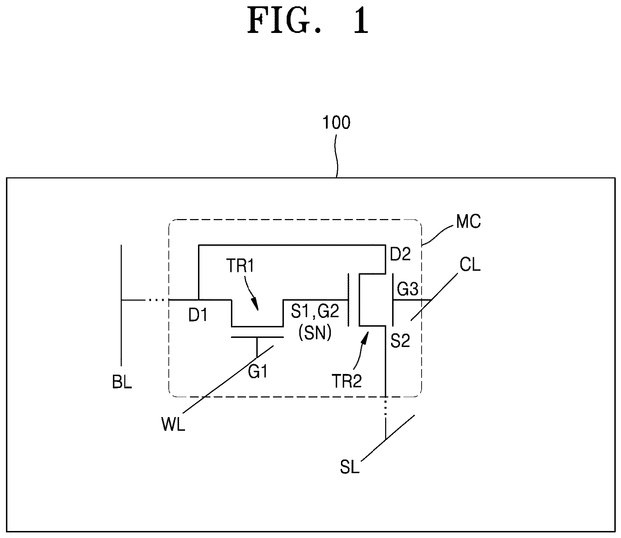

FIG. 1 is a schematic circuit diagram illustrating a capacitor-less memory device 100 according to an embodiment of the present invention.

Referring to FIG. 1, the capacitor-less memory device 100 may include a memory cell (MC). The memory device 100 may process data using the memory cell MC, and the memory cell MC may store and read data without a capacitor. The memory device 100 may include a dynamic random access memory (DRAM) device.

More specifically, the memory cell MC may include a write transistor TR1 and a read transistor TR2. The write transistor TR1 may include a first gate G1, a first drain D1, and a first source S1, and the read transistor TR2 may include a second gate G2, a second drain D2, a second source S2, and a back gate G3. For example, the write transistor TR1 and the read transistor TR2 may be provided as metal-oxide-semiconductor field-effect transistors (MOSFETs).

In the memory cell MC, the second gate G2 of the read transistor TR2 may be connected to the first source S1 of the write transistor TR1 to operate as a storage node SN.
For example, the first source S1 and the second gate G2 may be physically separated but may be interpreted as being electrically connected. In another example, the first source S1 and the second gate G2 may be integrally formed without being separated from each other, thereby performing both the function of the first source S1 and the function of the second gate G2 simultaneously. In this case, the first source S1 and the second gate G2 may not be separately referred to, and one of them or both may be collectively referred to as the storage node SN.

A bit line BL may be commonly connected to the first drain D1 of the write transistor TR1 and the second drain D2 of the read transistor TR2. Accordingly, the same operation signal may be applied to both the first drain D1 and the second drain D2 through the bit line BL. Such a structure can simplify the configuration of the memory cell MC, thereby reducing its area and simplifying its structure when vertically stacked.

In some embodiments, a row select transistor (not shown) may be additionally provided between the bit line BL and the memory cell MC. For example, the row select transistor may be connected between the bit line BL and the first drain D1 of the write transistor TR1. When a plurality of memory cells MC are arranged in multiple rows, the row select transistor STR1 may control the connection between the bit line BL and the corresponding memory cell MC.

Furthermore, a word line WL may be connected to the first gate G1 of the write transistor TR1. Through a control signal applied to the word line WL, the on or off state of the write transistor TR1 may be controlled. For example, when a write operation voltage is applied to the word line WL, the write transistor TR1 may be turned on, and when an off voltage is applied to the word line WL, the write transistor TR1 may be turned off.

In the memory cell MC, the second gate G2 of the read transistor TR2 is not connected to an external terminal but may receive an output signal from the first source S1 of the write transistor TR1. The read transistor TR2 may be controlled by the back gate G3. A control line CL may be connected to the back gate G3, and the on or off state of the read transistor TR2 may be controlled through a control signal applied to the control line CL. For example, when an operation voltage is applied to the control line CL, the read transistor TR2 may be turned on, and when an off voltage is applied to the control line CL, the read transistor TR2 may be turned off.

In some embodiments, a select line SL may be connected to the second source S2 of the read transistor TR2. For example, a separate electrical signal may be applied to the select line SL. In another example, when it is not necessary to apply a separate electrical signal through the select line SL, the select line SL may be omitted, and the second source S2 of the read transistor TR2 may be connected to a ground portion.

In some embodiments, a column select transistor (not shown) may be further connected between the second source S2 and the select line SL. When a plurality of memory cells MC are arranged in multiple columns, the column select transistor may control the connection between the select line SL and the corresponding memory cell MC.

The memory cell MC may store a data state in the storage node SN and may read the data state of the storage node SN. For example, the read transistor TR2 may be turned on or turned off depending on a data state of the storage node SN or a control voltage applied to the control line CL.

Hereinafter, the operation of the memory device 100 will be described in more detail.

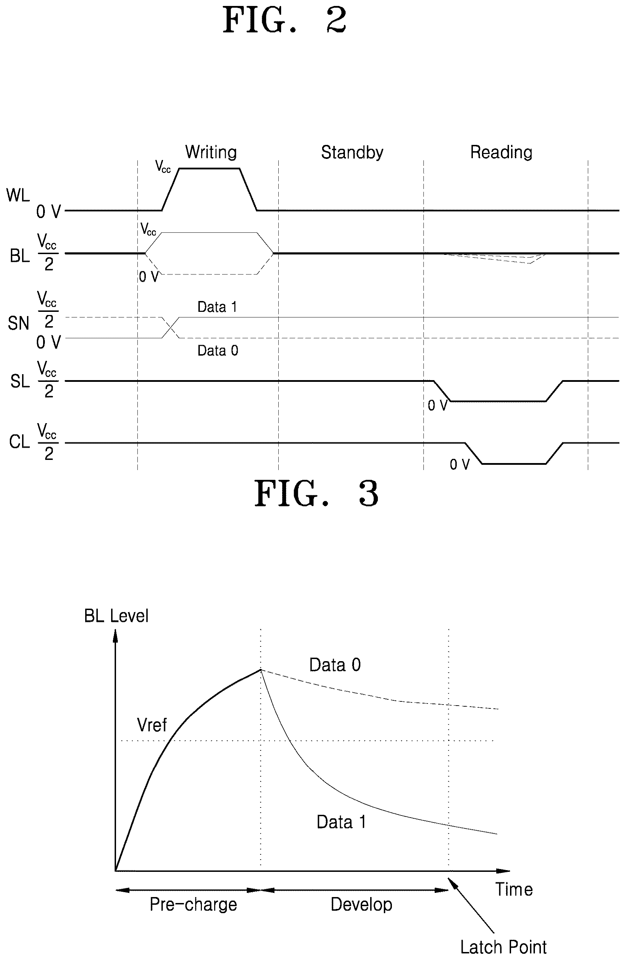

FIG. 2 is a timing chart exemplarily illustrating an operation of the capacitor-less memory device 100 of FIG. 1, and FIG. 3 is a graph showing a voltage change of a bit line during a read operation of the capacitor-less memory device 100 of FIG. 1.

Referring to FIGS. 1 to 3 together, a write operation for storing data in the storage node SN of the memory cell MC and a read operation for reading data stored in the storage node SN may be performed. The data stored in the storage node SN may include a first data state (Data 1) and a second data state (Data 0). For example, the first data state (Data 1) refers to a state in which a first data voltage (for example, Vcc/2) is stored in the storage node SN, and the second data state (Data 0) refers to a state in which a second data voltage (for example, 0 V) is stored in the storage node SN. The first data voltage (Vcc/2) may be greater than the second data voltage (0 V), and accordingly, the first data state (Data 1) may represent a relatively high-level state, and the second data state (Data 0) may represent a relatively low-level state.

More specifically, during a write operation for storing the first data state (Data 1) in the storage node SN of the memory cell MC, a write operation voltage (for example, Vcc) may be applied to the word line WL and the bit line BL. Additionally, a precharge voltage (for example, Vcc/2) or an off voltage (for example, 0 V) may be applied to the control line CL.

In this context, the write operation voltage (Vcc) may be selected to be higher than the threshold voltage of the read transistor TR2 so that a precharge voltage (Vcc/2) higher than the threshold voltage can be stored in the storage node SN. For example, the write operation voltage (Vcc) may be twice the precharge voltage (Vcc/2). The off voltage (0 V) may be lower than the threshold voltages of the write transistor TR1 and the read transistor TR2 to turn off the write transistor TR1 or the read transistor TR2. For instance, the off voltage may be 0 V.

In some embodiments, during the write operation of the first data state (Data 1), a precharge voltage (for example, Vcc/2) or a write operation voltage (Vcc) may be applied to the select line SL.

In some embodiments, during the write operation of the first data state (Data 1), the voltage of the bit line BL may increase from a precharge voltage (for example, Vcc/2) to a write operation voltage (Vcc). Accordingly, as the write transistor TR1 is turned on, the voltage of the storage node SN may rise to the first data voltage (Vcc/2). Such a write operation for the first data may also be referred to as a data storage operation.

During a write operation for storing the second data state (Data 0) in the storage node SN of the memory cell MC, a write operation voltage (Vcc) may be applied to the word line WL, an off voltage (0 V) may be applied to the bit line BL, and a precharge voltage (Vcc/2) or an off voltage (0 V) may be applied to the control line CL. Accordingly, as the write transistor TR1 is turned on, the voltage of the storage node SN may decrease to the second data voltage (0 V). Such a write operation for the second data state (Data 0) may also be referred to as a data erase operation.

In some embodiments, during the write operation of the second data state (Data 0), a precharge voltage (for example, Vcc/2) or an off voltage (0 V) may be applied to the select line SL.

In a standby operation, an off voltage (0 V) may be applied to the word line WL, and a precharge voltage (Vcc/2) may be applied to the bit line BL, the control line CL, and the select lines SL. In this case, as the write transistor TR1 is turned off, the data state of the storage node SN may be maintained. For example, the voltage of the storage node SN may be maintained at the first data state (Vcc/2) or the second data state (for example, 0 V).

In a read operation, an off voltage (0 V) may be applied to the word line WL, an off voltage (0 V) may be applied to the control line CL and the select line SL, and the voltage of the bit line BL may be read. For example, a data state may be read by sensing a degree of voltage drop from the precharge voltage (Vcc/2) in the bit line BL. In this case, the write transistor TR1 may be turned off, and the read transistor TR2 may be turned on or turned off depending on the data state of the storage node SN. For example, the precharge voltage (Vcc/2) may be greater than the threshold voltage of the read transistor TR2. Accordingly, when the precharge voltage (Vcc/2) is stored in the storage node SN of the read transistor TR2, the read transistor TR2 may be turned on.

For example, when the storage node SN is in the first data state (Data 1), the read transistor TR2 may be turned on, and a current may flow through the read transistor TR2, thereby causing the voltage of the bit line BL to decrease by a predetermined amount from the precharge voltage (Vcc/2). In another example, when the storage node SN is in the second data state (Data 0), the read transistor TR2 may be turned off, and the voltage of the bit line BL may remain substantially unchanged from the precharge voltage (Vcc/2).

However, as shown in FIG. 3, since a small leakage current may exist in the read transistor TR2, the voltage of the bit line BL may slightly drop from the precharge voltage (Vcc/2) even in the second data state (Data 0). For example, during the read operation, the voltage of the bit line BL in the first data state (Data 1) may be greater than a reference voltage (Vref), and the voltage of the bit line BL in the second data state (Data 0) may be smaller than the reference voltage (Vref).

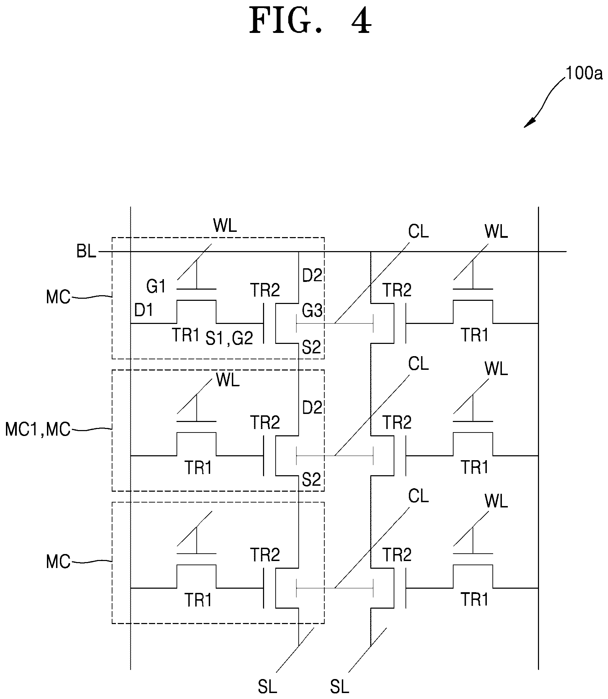

FIG. 4 is a schematic circuit diagram illustrating a capacitor-less memory device 100a according to another embodiment of the present invention. The memory device 100a may represent a case in which some configurations of the memory device 100 shown in FIG. 1 are modified or added. Accordingly, the two embodiments may refer to each other, and therefore, redundant descriptions will be omitted.

Referring to FIGS. 1 and 4 together, the capacitor-less memory device 100a may include a plurality of memory cells MC. For example, the memory cells MC may be vertically stacked. Furthermore, the memory cells MC may also be arranged in a two-dimensional array form.

Each memory cell MC may include a write transistor TR1 and a read transistor TR2, which may refer to the description of FIG. 1.

The memory cells MC may include a plurality of write transistors TR1 vertically stacked and a plurality of read transistors TR2 vertically connected to each other. For example, the write transistors TR1 may be vertically aligned in a stack, and the read transistors TR2 may be serially connected along a vertical string. In another example, a second drain D2 and a second source S2 of two vertically adjacent read transistors TR2 may be connected to each other.

A bit line BL may be connected to the first drains D1 of the memory cells MC. Furthermore, the bit line BL may be connected to the second drain D2 of an uppermost read transistor TR2 among the plurality of read transistors TR2. A plurality of word lines WL may be respectively connected to the first gates G1 of the memory cells MC. A plurality of control lines CL may be respectively connected to the back gates G3 of the memory cells MC.

In some embodiments, a select line SL may be connected to the second source S2 of a lowermost read transistor TR2 among the plurality of read transistors TR2. Accordingly, the read transistors TR2 may be connected in series between the bit line BL and the select line SL. Therefore, in the vertically stacked memory cells MC, a current may flow from the bit line BL to the select line SL through the read transistors TR2 only when all of the read transistors TR2 are turned on.

In some embodiments, in two memory cells MC that are adjacently arranged in the same row, two back gates G3 may be connected to the same control line CL.

In the memory device 100a, each read transistor TR2 may be turned on or turned off depending on a data state of the storage node SN or a control voltage applied to the back gate G3 through the control line CL.

In some embodiments, among the memory cells MC, a memory cell MC1 disposed in the second layer and the first column may be selected as an example, and a write operation and a read operation may be performed for the selected memory cell MC1.

Hereinafter, various embodiments regarding the operation of the memory device 100a will be described in more detail.

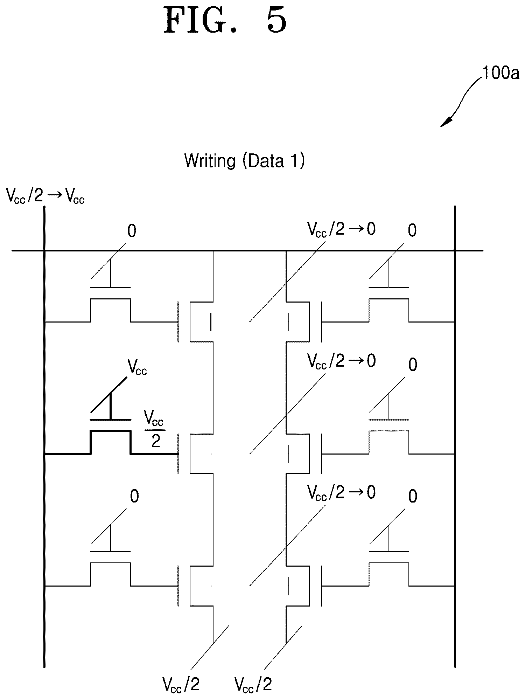

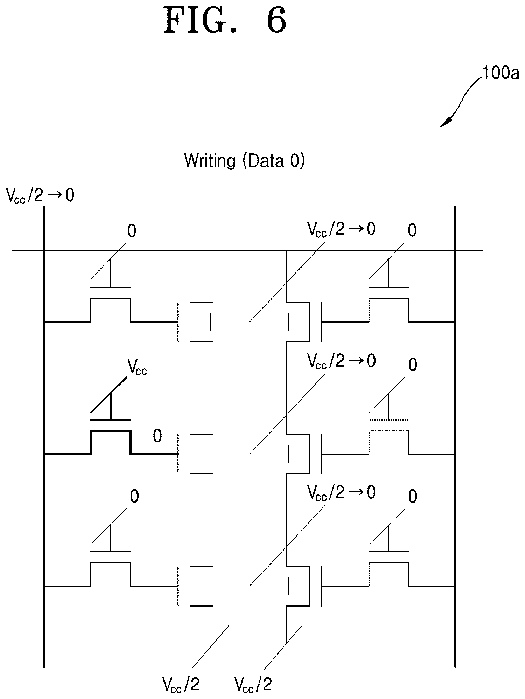

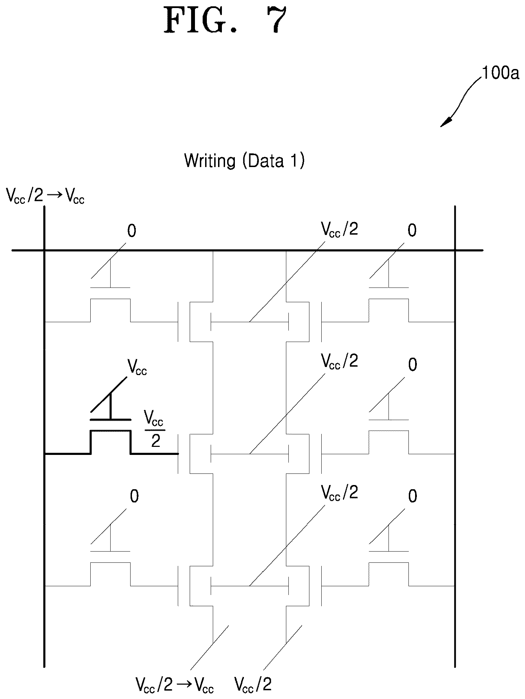

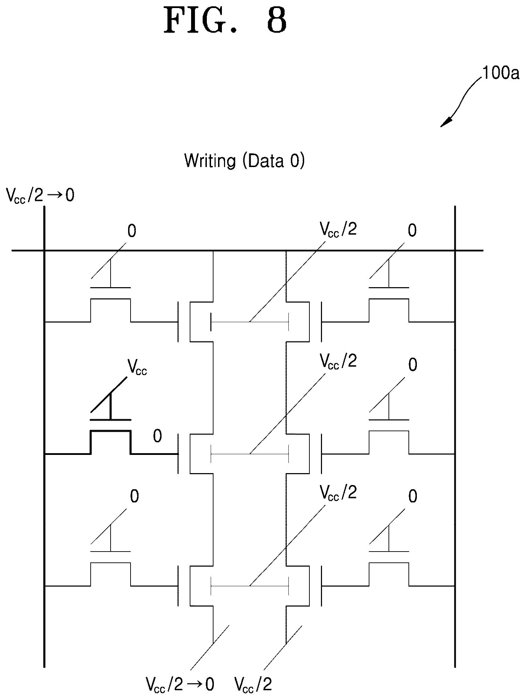

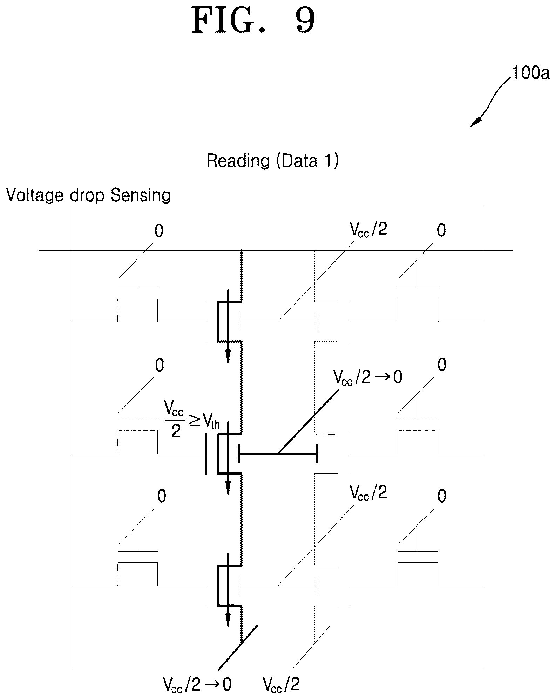

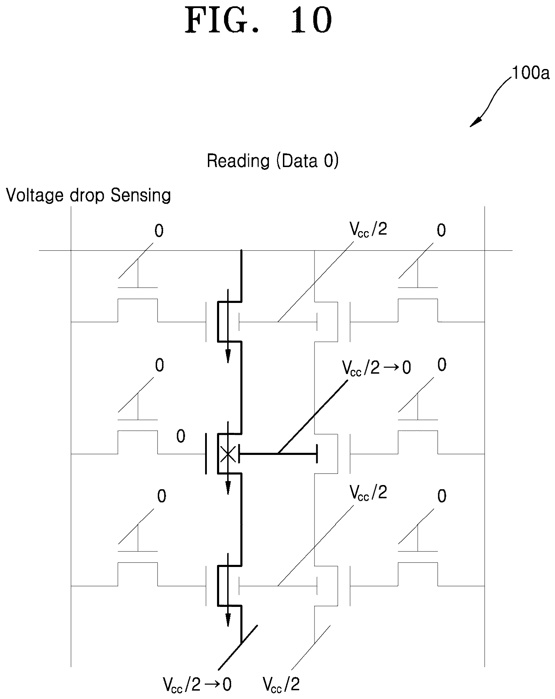

FIGS. 5 through 10 are schematic circuit diagrams illustrating operation methods of the capacitor-less memory device shown in FIG. 4.

Referring to FIGS. 1, 4, and 5 together, a write operation may be performed to store a first data state (Data 1) in the storage node SN of a selected memory cell MC1 among the memory cells MC.

More specifically, during a write operation for storing the first data state (Data 1) in the storage node SN of the selected memory cell MC1, a write operation voltage (Vcc) may be applied to the bit line BL, a write operation voltage (Vcc) may be applied to the word line WL connected to the selected memory cell MC1 among the plurality of word lines WL, an off voltage (0 V) may be applied to the remaining word lines WL, an off voltage (0 V) may be applied to the control line CL, and a precharge voltage (Vcc/2) may be applied to the select line SL.

For example, during the write operation of the first data state (Data 1), the voltage of the bit line BL may increase from the precharge voltage (Vcc/2) to the write operation voltage (Vcc). In this case, as the write transistor TR1 in the selected memory cell MC1 is turned on, the voltage of the storage node SN in the selected memory cell MC1 may rise to the first data voltage (Vcc/2). Such a write operation for the first data state may also be referred to as a data storage operation.

Referring to FIGS. 1, 4, and 7, another example of the write operation for storing the first data state (Data 1) may be provided. For example, during the write operation of the first data state (Data 1), a write operation voltage (Vcc) may be applied to the bit line BL, a write operation voltage (Vcc) may be applied to the word line WL connected to the selected memory cell MC1 among the plurality of word lines WL, an off voltage (0 V) may be applied to the remaining word lines WL, a precharge voltage (Vcc/2) may be applied to the control line CL, and a write operation voltage (Vcc) may be applied to the select line SL. Accordingly, as the write operation voltage (Vcc) is applied to the select line SL, a current flow through the read transistors TR2 may be reduced or blocked.

Referring to FIGS. 1, 4, and 6, a write operation may be performed to store a second data state (Data 0) in the storage node SN of the selected memory cell MC1 among the memory cells MC.

For example, during a write operation for storing a second data state (Data 0) in the storage node SN of the selected memory cell MC1, an off voltage (0 V) may be applied to the bit line BL, a write operation voltage (Vcc) may be applied to the word line WL of the selected memory cell MC1, an off voltage (0 V) may be applied to the remaining word lines WL, an off voltage (0 V) may be applied to the control line CL, and a precharge voltage (Vcc/2) may be applied to the select line SL.

Accordingly, as the write transistor TR1 in the selected memory cell MC1 is turned on, the voltage of the storage node SN may decrease to the second data voltage (0 V). Such a write operation for the second data state may also be referred to as a data erase operation.

Referring to FIGS. 1, 4, and 8, another example of the write operation for storing the second data state (Data 0) may be provided. For example, during the write operation of the second data state (Data 0), an off voltage (0 V) may be applied to the bit line BL, a write operation voltage (Vcc) may be applied to the word line WL of the selected memory cell MC1, an off voltage (0 V) may be applied to the remaining word lines WL, a precharge voltage (Vcc/2) may be applied to the control line CL, and an off voltage (0 V) may be applied to the select line SL. Accordingly, a current flow through the read transistors TR2 may be reduced or blocked.

Referring to FIGS. 1, 4, and 9, a read operation may be performed to read a data state of the storage node SN of a selected memory cell MC1 among the plurality of memory cells MC.

More specifically, to read the data state of the selected memory cell MC1 among the plurality of memory cells MC, an off voltage (0 V) may be applied to the word lines WL, an off voltage (0 V) may be applied to the control line CL connected to the back gate G3 of the selected memory cell MC1, a precharge voltage (Vcc/2) may be applied to the remaining control lines CL, an off voltage (0 V) may be applied to the select line SL, and a degree of voltage drop-for example, a drop from the precharge voltage (Vcc/2)-may be sensed at the bit line BL.

For example, when the selected memory cell MC1 has the first data state (Data 1), the storage node SN of the selected memory cell MC1 may have the first data voltage (Vcc/2).
Accordingly, the voltage of the second gate G2 of the selected memory cell MC1 may be greater than a threshold voltage (Vth), such that the read transistor TR2 of the selected memory cell MC1 may be turned on. The control lines CL of other memory cells MC vertically connected to the selected memory cell MC1 may also receive the precharge voltage (Vcc/2) and thus may also be turned on. Therefore, a current may flow through the read transistors TR2 of the selected memory cell MC1 and other vertically connected memory cells MC, causing the voltage of the bit line BL to drop by a predetermined amount from the precharge voltage (Vcc/2).

Referring to FIGS. 1, 4, and 10, a read operation may be performed to read the second data state (Data 0) of the storage node SN of a selected memory cell MC1 among the plurality of memory cells MC. More specifically, when the selected memory cell MC1 has the second data state (Data 0), the storage node SN of the selected memory cell MC1 may have the second data voltage (0 V). Accordingly, the voltage of the second gate G2 of the selected memory cell MC1 may be lower than the threshold voltage (Vth), such that the read transistor TR2 of the selected memory cell MC1 may be turned off. Therefore, no current may flow through the selected memory cell MC1, and the voltage of the bit line BL may be maintained at the precharge voltage (Vcc/2) or may slightly decrease within a very small voltage range due to a leakage current.

Accordingly, in the capacitor-less memory device 100a, the memory cells MC may be arranged in a two-dimensional array, and further in a three-dimensional vertical array, thereby increasing the integration density of the memory cells MC. In addition, by employing a common connection structure for the bit line BL, the circuit configuration may be simplified. Therefore, the unit area of each memory cell MC may be reduced, and the stacking structure may be simplified. Furthermore, by sharing control lines among adjacent memory cells MC, the overall integration density of the capacitor-less memory device 100a may be further enhanced.

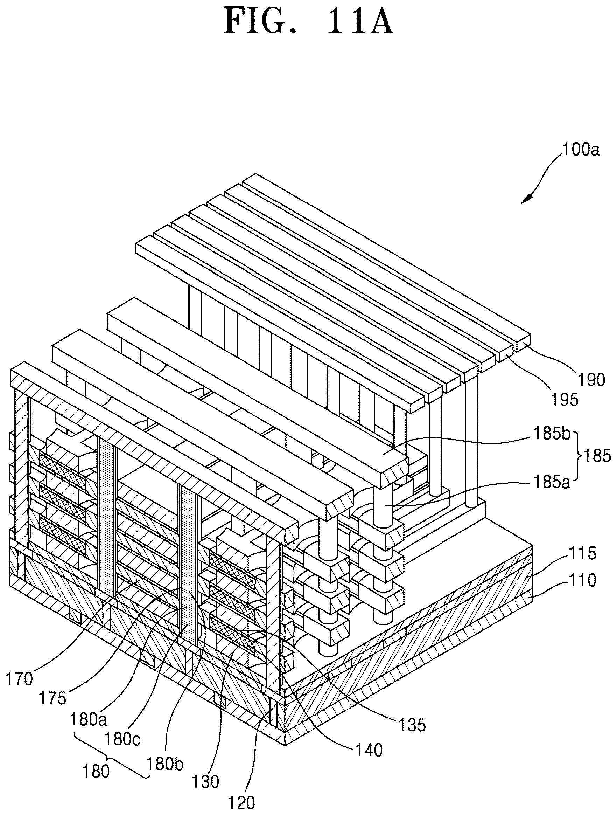

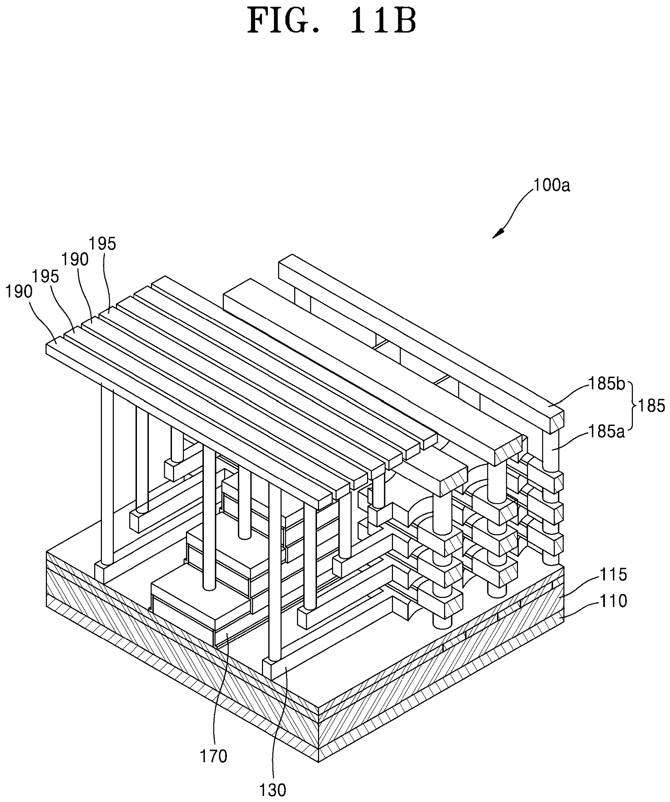

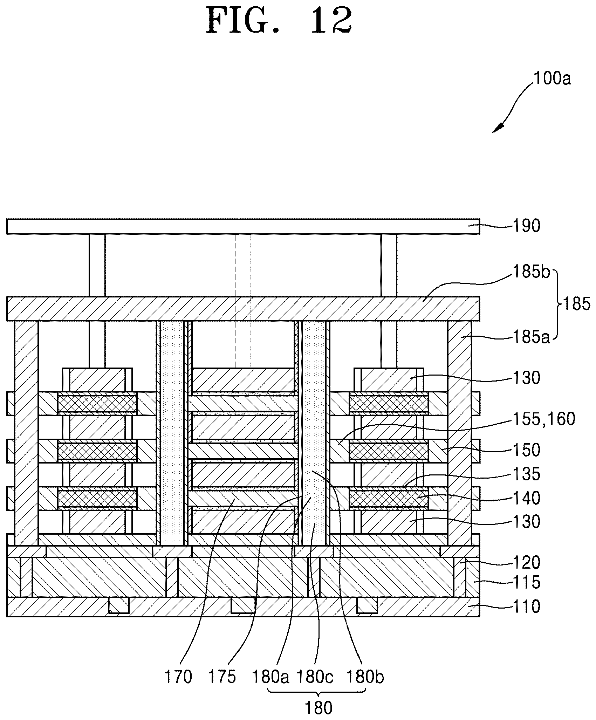

FIGS. 11A and 11B are schematic perspective views of a capacitor-less memory device 100b according to another embodiment of the present invention, viewed from the front and rear sides, respectively, and FIG. 12 is a schematic cross-sectional view of the capacitor-less memory device 100b shown in FIGS. 11A and 11B.

Referring to FIGS. 11A, 11B, and 12, a capacitor-less memory device 100b may include a plurality of first semiconductor layers 140, a plurality of first gate electrode layers 130, a second semiconductor layer 180, a plurality of second gate electrode layers 160, and a plurality of back gate electrode layers 170.

More specifically, a substrate 110 may be provided. For example, the substrate 110 may include a semiconductor wafer such as silicon, silicon carbide, gallium nitride, gallium oxide, germanium, or silicon-germanium. In some embodiments, the substrate 110 may include a semiconductor wafer and at least one epitaxial layer (not shown) grown thereon. For example, the substrate 110 may have a silicon-on-insulator (SOI) structure.

In some embodiments, an isolation layer (not shown) may be formed in the substrate 110. Furthermore, at least one active device, such as a transistor, may be formed on the substrate 110.

The plurality of first semiconductor layers 140 may be stacked on the substrate 110 spaced apart from each other. For example, an interlayer insulating layer 115 may be formed on the substrate 110, and a plurality of first semiconductor layers 140 may be spaced apart from each other and stacked thereon. For example, each of the first semiconductor layers 140 may include a semiconductor material, such as an oxide semiconductor. For instance, the first semiconductor layers 140 may include an oxide semiconductor such as indium gallium zinc oxide (IGZO). Each of the first semiconductor layers 140 may be formed in various shapes, for example, in the form of a wire or a plate.

A plurality of first gate electrode layers 130 may be disposed between the first semiconductor layers 140. For example, a first gate electrode layer 130 may be disposed between each pair of adjacent first semiconductor layers 140. The first gate electrode layers 130 may be formed of a conductive material such as doped polysilicon or metal.

A first gate insulating layer 135 may be provided between the first semiconductor layers 140 and the first gate electrode layers 130. For example, the first gate insulating layer 135 may be formed on surfaces of the first semiconductor layers 140, and the first gate electrode layers 130 may be formed on the first gate insulating layer 135. For example, the first gate insulating layer 135 may be formed by depositing an insulating material on the first semiconductor layers 140.

A plurality of first drain electrode layers 150 may be respectively connected to one side of the plurality of first semiconductor layers 140, and a plurality of first source electrode layers 155 may be respectively connected to the opposite sides of the plurality of first semiconductor layers 140. For example, the first drain electrode layers 150 and the first source electrode layers 155 may include a conductive material such as metal. In another example, the first drain electrode layers 150 and the first source electrode layers 155 may be portions of the first semiconductor layers 140 that are exposed from both sides of the first gate electrode layers 130.

The combination structure of the first semiconductor layer 140, the first gate electrode layer 130, the first drain electrode layer 150, and the first source electrode layer 155 may constitute a write transistor TR1 in the memory cell MC shown in FIG. 1. For example, the first semiconductor layer 140, the first gate electrode layer 130, the first drain electrode layer 150, and the first source electrode layer 155 may respectively correspond to the channel, the first gate G1, the first drain D1, and the first source S1 of the write transistor TR1 in FIG. 1.

Furthermore, the stacked structure of the first semiconductor layers 140, the first gate electrode layers 130, the first drain electrode layers 150, and the first source electrode layers 155 may correspond to the stacked structure of the write transistors TR1 in the memory device 100a shown in FIG. 4.

Meanwhile, the plurality of second gate electrode layers 160 may be respectively connected to the first source electrode layers 155. For example, the second gate electrode layers 160 may be formed of a conductive material such as doped polysilicon or metal.

The second semiconductor layer 180 may extend vertically across the plurality of second gate electrode layers 160. For example, the second semiconductor layer 180 may include a semiconductor material such as an oxide semiconductor. For instance, the second semiconductor layer 180 may include an oxide semiconductor such as indium gallium zinc oxide (IGZO). The second semiconductor layer 180 may have various shapes, for example, a vertical pillar shape.

The plurality of back gate electrode layers 170 may be respectively disposed on sides of the second semiconductor layer 180 opposite to the plurality of second gate electrode layers 160. For example, the second gate electrode layers 160 may be vertically spaced apart from each other on one side of the second semiconductor layer 180, and the back gate electrode layers 170 may be vertically spaced apart from each other on the other side of the second semiconductor layer 180. The back gate electrode layers 170 and the second gate electrode layers 160 may be disposed on the same layer with the second semiconductor layer 180 interposed therebetween.

A second gate insulating layer 175 may be provided between the second gate electrode layers 160 and the second semiconductor layer 180 and between the back gate electrode layers 170 and the second semiconductor layer 180. For example, the second gate insulating layer 175 may be formed by depositing an insulating material on the second semiconductor layer 180.

The combined structure of the second semiconductor layer 180, the second gate electrode layer 160, and the back gate electrode layer 170 may constitute a read transistor TR2 of the memory cell MC shown in FIG. 1.
For example, the second semiconductor layer 180, the second gate electrode layer 160, and the back gate electrode layer 170 may respectively correspond to the channel, the second gate G2, and the back gate G3 of the read transistor TR2 in FIG. 1.

Furthermore, the stacked structure of the second semiconductor layer 180, the second gate electrode layers 160, and the back gate electrode layers 170 may correspond to the stacked structure of the read transistors TR2 in the memory device 100a shown in FIG. 4.

In some embodiments, the second drain electrode layers 180b and the second source electrode layers 180c may be provided as portions of the second semiconductor layer 180. For example, portions of the second semiconductor layer 180 facing the second gate electrode layers 160 may function as channel layers 180a. The channel layers 180a may refer to portions of the second semiconductor layer 180 located between the second gate electrode layers 160 and the back gate electrode layers 170. Furthermore, portions of the second semiconductor layer 180 between the channel layers 180a may function as the second drain electrode layers 180b and the second source electrode layers 180c.

The second drain electrode layer 180b and the second source electrode layer 180c may respectively correspond to the second drain D2 and the second source S2 of the read transistor TR2 shown in FIG. 1. Accordingly, in adjacent memory cells MC, the second drain electrode layer 180b and the second source electrode layer 180c may be connected to each other.

In some embodiments, the first source electrode layer 155 and the second gate electrode layer 160 that are disposed on the same layer may be integrally formed with each other.

In some embodiments, a plurality of word lines 190 may be respectively connected to the first gate electrode layers 130, and a plurality of control lines 195 may be respectively connected to the back gate electrode layers 170. For example, the word lines 190 and the control lines 195 may be alternately arranged.

In some embodiments, a bit line 185 may be connected to the first drain electrode layers 150, and the second semiconductor layer 180 may be connected to an upper end of the bit line 185. More specifically, the bit line 185 may be commonly connected to the uppermost second drain electrode layer 180b of the second semiconductor layer 180 and to the vertically stacked first drain electrode layers 150.

For example, the bit line 185 may include a vertical electrode 185a that extends vertically to be commonly connected to the vertically stacked first drain electrode layers 150, and a horizontal electrode 185b that extends horizontally to be connected to an upper end of the second semiconductor layer 180. The vertical electrode 185a and the horizontal electrode 185b may be connected to each other.

In some embodiments, the first semiconductor layers 140 may each have a planar shape, and the second semiconductor layer 180 may have a pillar shape. For example, the first semiconductor layers 140 may have a thin rectangular plate shape, and the second semiconductor layer 180 may have a cylindrical or elliptical pillar shape.

In some embodiments, via electrodes 120 formed in the interlayer insulating layer 115 may be provided. For example, the via electrodes 120 may connect the substrate 110 and a lower end of the second semiconductor layer 180, or may connect the substrate 110 and the bit line 185.

In some embodiments, a select line (not shown) may be additionally provided on the substrate 110 to be connected to a lower end of the second semiconductor layer 180, or a portion of the substrate 110 connected to the lower end of the second semiconductor layer 180 may function as a select line.

According to the memory device 100a described above, the first semiconductor layers 140 may be stacked, and the second semiconductor layer 180 may be formed as a vertical pillar, thereby enabling the formation of vertically stacked memory cells (MC in FIG. 4) with high integration density. Furthermore, the bit line 185 may be formed such that the vertical electrode 185a and the horizontal electrode 185b are connected to each other, thereby simplifying the connection structure. In addition, by sharing the back gate electrode layers 170 between adjacent second semiconductor layers 180, the integration density may be further increased.

Although the present invention has been described with reference to the embodiments illustrated in the drawings, these embodiments are merely exemplary. It will be understood by those skilled in the art that various modifications and equivalent other embodiments can be made from these examples. Therefore, the true technical scope of the present invention should be determined by the technical spirit of the appended claims.

## Claims

1. A capacitor-less memory device comprising:
a memory cell including a write transistor having a first gate, a first drain, and a first source, and a read transistor having a second gate, a second drain, a second source, and a back gate, wherein the second gate is connected to the first source to operate as a storage node;
a bit line commonly connected to the first drain and the second drain;
a word line connected to the first gate;
a control line connected to the back gate; and
a select line connected to the second source,
wherein the read transistor is turned on or turned off depending on a data state of the storage node or a control voltage applied to the control line.

2. The capacitor-less memory device of claim 1, wherein, to store a first data state in the storage node of the memory cell, a write operation voltage is applied to the bit line and the word line, an off voltage or a precharge voltage is applied to the control line, and a precharge voltage or a write operation voltage is applied to the select line.

3. The capacitor-less memory device of claim 1 or 2, wherein, to store a second data state in the storage node of the memory cell, a write operation voltage is applied to the word line, an off voltage is applied to the bit line, an off voltage or a precharge voltage is applied to the control line, and a precharge voltage or an off voltage is applied to the select line.

4. The capacitor-less memory device of any one of claims 1 to 3, wherein, to read a data state of the memory cell, an off voltage is applied to the word line and the control line, an off voltage is applied to the select line, and a degree of voltage drop is sensed at the bit line.

5. A capacitor-less memory device comprising:
a plurality of vertically stacked memory cells, the plurality of memory cells including a plurality of write transistors each having a first gate, a first drain, and a first source, and a plurality of read transistors each having a second gate, a second drain, a second source, and a back gate, wherein the second gate is connected to the first source to operate as a storage node, the plurality of read transistors being connected vertically to one another;
a bit line connected to the first drain of the plurality of memory cells and to the second drain of an uppermost one of the plurality of read transistors;
a plurality of word lines respectively connected to the first gates of the plurality of memory cells;
a plurality of control lines respectively connected to the back gates of the plurality of memory cells; and
a select line connected to the second source of a lowermost one of the plurality of read transistors,
wherein each read transistor is turned on or turned off depending on a data state of the storage node or a control voltage applied to the back gate.

6. The capacitor-less memory device of claim 5, wherein, to store a first data state in the storage node of a selected one of the plurality of memory cells, a write operation voltage is applied to the bit line, a write operation voltage is applied to the word line connected to the selected memory cell among the plurality of word lines, an off voltage is applied to the remaining word lines, an off voltage or a precharge voltage is applied to the control line, and a precharge voltage or a write operation voltage is applied to the select line.

7. The capacitor-less memory device of claim 5 or 6, wherein, to store a second data state in the storage node of a selected one of the plurality of memory cells, an off voltage is applied to the bit line, a write operation voltage is applied to the word line connected to the selected memory cell among the plurality of word lines, an off voltage is applied to the remaining word lines, an off voltage or a precharge voltage is applied to the control line, and a precharge voltage or an off voltage is applied to the select line.

8. The capacitor-less memory device of any one of claims 5 to 7, wherein, to read a data state of a selected one of the plurality of memory cells, an off voltage is applied to the plurality of word lines, an off voltage is applied to the control line connected to the back gate of the selected memory cell among the plurality of control lines, a precharge voltage is applied to the remaining control lines, an off voltage is applied to the select line, and a degree of voltage drop is sensed at the bit line.

9. A capacitor-less memory device comprising: \\\ a plurality of first semiconductor layers stacked on a substrate and spaced apart from each other;
a plurality of first gate electrode layers disposed between the plurality of first semiconductor layers;
a first gate insulating layer interposed between the plurality of first semiconductor layers and the plurality of first gate electrode layers;
a plurality of first drain electrode layers respectively connected to sides of the plurality of first semiconductor layers;
a plurality of first source electrode layers respectively connected to opposite sides of the plurality of first semiconductor layers;
a plurality of second gate electrode layers respectively connected to the plurality of first source electrode layers;
a second semiconductor layer extending vertically across the plurality of second gate electrode layers;
a plurality of back gate electrode layers respectively disposed on sides of the second semiconductor layer opposite to the plurality of second gate electrode layers;
a second gate insulating layer interposed between the plurality of second gate electrode layers and the second semiconductor layer and between the plurality of back gate electrode layers and the second semiconductor layer;
a plurality of word lines respectively connected to the plurality of first gate electrode layers; and
a bit line connected to the plurality of first drain electrode layers and connected to an upper end of the second semiconductor layer,
wherein the plurality of second gate electrode layers are respectively used as a plurality of storage nodes.

10. The capacitor-less memory device of claim 9, wherein the bit line comprises:
a vertical electrode extending vertically to be connected to the plurality of first drain electrode layers; and
a horizontal electrode extending horizontally to be connected to an upper end of the second semiconductor layer and connected to the vertical electrode.

11. The capacitor-less memory device of claim 9 or 10, wherein the first source electrode layer and the second gate electrode layer disposed in the same layer among the plurality of first source electrode layers and the plurality of second gate electrode layers are integrally formed with each other.

12. The capacitor-less memory device of any one of claims 9 to 11, wherein portions of the second semiconductor layer facing the plurality of second gate electrode layers function as channel layers, and portions of the second semiconductor layer between the channel layers function as second drain electrode layers or second source electrode layers.

13. The capacitor-less memory device of any one of claims 9 to 12, wherein each of the plurality of first semiconductor layers has a planar shape, and the second semiconductor layer has a pillar shape.

14. The capacitor-less memory device of any one of claims 9 to 13, wherein the plurality of first semiconductor layers and the second semiconductor layer comprise an oxide semiconductor material.

15. The capacitor-less memory device of any one of claims 9 to 14, further comprising
an interlayer insulating layer on the substrate; and
via electrodes formed in the interlayer insulating layer to connect the substrate and a lower end of the second semiconductor layer or to connect the substrate and the bit line.
